## Europäisches Patentamt
## European Patent Office
## Office européen des brevets

(19)

(11) Veröffentlichungsnummer: **0 036 893**
**A1**

(12)
# EUROPÄISCHE PATENTANMELDUNG
Veröffentlicht nach Art. 158 Abs. 3 EPÜ

(21) Anmeldenummer: 80901970.6

(51) Int. Cl.³: **G 01 R 11/00**

(22) Anmeldetag: 08.10.80

Daten der zugrundeliegenden internationalen Anmeldung:

(86) Internationale Anmeldenummer:
PCT/JP80/00241

(87) Internationale Veröffentlichungsnummer:
WO81/01058 (16.04.81 81/09)

(30) Priorität: 11.10.79 JP 139658/79

(43) Veröffentlichungstag der Anmeldung:
07.10.81 Patentblatt 81/40

(84) Benannte Vertragsstaaten:
AT CH DE FR GB LI

(71) Anmelder: FUJI ELECTRIC CO. LTD.
1-1, Tanabeshinden, Kawasaki-ku
Kawasaki 210(JP)

(72) Erfinder: KAWAFUNE, Michio Fuji Electric Co., Ltd.
1-1, Tanabeshinden Kawasaki-ku, Kawasaki-shi
Kanagawa 210(JP)

(74) Vertreter: Mehl, Ernst, Dipl.-Ing.
Postfach 22 01 76
D-8000 München 22(DE)

(54) **ELEKTRIZITÄTS-MESSGERÄT.**

(57) Die Erfindung betrifft eine Schaltungsanordnung zur Erfassung elektrischer Energie, die folgende Funktionselemente aufweist:

- einen Leistungs-Strom-Wandler (1) zur Bildung des Produktes aus Strom und Spannung einer elektrischen Versorgungsleitung, deren Energiefluß in Abhängigkeit von der Richtung dieses Energieflusses in positive bzw. negative Richtung erfaßt werden soll,
- einen Integrator (3), dem das Ausgangssignal des Leistungs-Strom-Wandlers (1) zugeführt ist,
- ein Schwellwertglied (4) zur Überwachung der Höhe der Ausgangsspannung des Integrators (3),
- eine Stromquelle (8), die für eine vorgegebene Zeitspanne ($2$) zusammen mit dem Ausgangssignal ($I_p$) des Leistungs-Strom-Wandlers (1) in den Integrator (3) einen konstanten Strom ($I_0$) einspeist, der bezüglich des vom Leistungs-Strom-Wandler (1) stammenden Eingangssignals umgekehrte Stromflußrichtung aufweist, wodurch das Ausgangssignal ($V_p$) des Integrators (3) umgekehrt wird,
- Zähleinrichtungen (12, 14) zur Erfassung der Zahl der Änderungen des Ausgangssignals des Integrators (3), die in Form einer Impulsfrequenz zur Verfügung steht,
- Schalter ($2_1$, $2_2$) zum Umschalten der Eingangspolarität des vom Leistungs-Strom-Wandler (1) stammenden Signals in umgekehrte Richtung für den Integrator (3),
- Steuerkreise (9, 10) zum Betätigen der Schalter ($2_1$, $2_2$), wenn die Energieflußrichtung sich umkehrt, so daß das Ausgangssignal des Integrators (3) einen vorgegebenen Schwellwert überschreitet und zum Umschalten der Zähleinrichtungen (12,14) entsprechend der Richtung des Energieflusses. Durch die Erfindung kann die Erfassung der elektri-

./...

COMPLETE DOCUMENT

EP 0 036 893 A1

Schaltungsanordnung zur Erfassung von elektrischer
Energie

(Es wird die Priorität der japanischen Gebrauchs-
musteranmeldung J 54-1396 58 vom 11.10.79 beansprucht)

Technisches Gebiet

Die Erfindung betrifft eine Schaltungsanordnung zur
Erfassung elektrischer Energie nach dem Ladungskompen-
sationsverfahren, die folgende Funktionselemente auf-
weist:

- einen Leistungs-Strom-Wandler zur Bildung des Produktes aus Strom und Spannung einer elektrischen
Versorgungsleitung, deren Energiefluß in Übereinstimmung mit der Richtung des Energieflusses in
positive bzw. negative Richtung erfaßt werden soll,

- einen Integrator, dem das Ausgangssignal des
Leistungs-Strom-Wandlers zugeführt ist,

- ein Schwellwertglied zur Überwachung der Höhe der
Ausgangsspannung des Integrators,

- eine Stromquelle, die in Abhängigkeit vom Grenzwertsignal des Schwellwertgliedes für eine vorgegebene
Zeitspanne zusätzlich zu dem Ausgangssignal des
Leistungs-Strom-Wandlers in den Integrator einen
konstanten Strom einspeist, der bezüglich des vom
Leistungs-Strom-Wandler stammenden Eingangssignals
umgekehrte Polarität aufweist, wodurch der Verlauf
des Ausgangssignals des Integrators umgekehrt wird,
und

- Zähleinrichtungen zur Erfassung der Zahl der Umkehrungen des Ausgangssignals des Integrators, die in
Form einer Impulsfrequenz zur Verfügung stehen.

- 2 -

Die erfindungsgemäße Schaltungsanordnung zur Erfassung elektrischer Energie ermöglicht es, unter Einsatz nur eines einzigen Erfassungssystems den Energiefluß bei wechselnden Energieflußrichtungen (in einer Werksanlage und einer Betriebsanlage) unter einer Vielzahl von Quellen elektrischer Energie zu erfassen.

Stand der Technik

Für den wechselseitigen Austausch elektrischer Energie zwischen verschiedenen elektrischen Energieversorgungsstationen wird eine Schaltungsanordnung zur Erfassung elektrischer Energie sinnvoll eingesetzt, um einen abgegebenen oder empfangenen elektrischen Energiefluß zu erfassen.

Als Schaltungsanordnung zur Erfassung elektrischer Energie dieser Art ist beispielsweise in der japanischen Gebrauchsmusterschrift Nr. 52-1733 ein System offenbart, bei dem solche Stromsignale in positive und entgegengesetzte Richtung, die der zu erfassenden elektrischen Leistung eines Versorgungsnetzes proportional sind, mittels eines Leistungs-Strom-Wandlers gewonnen sind. Hierbei sind derartige Strom-Frequenz-Wandler zum Betrieb in positive und negative Richtung eingesetzt, die jeweils auf einen dieser beiden, positiven oder negativen Ströme jener Stromsignale ansprechen und dabei Impulse entsprechender Frequenz erzeugen. Dabei wird die die Leistung in den beiden Energieflußrichtungen in Übereinstimmung mit den impulsförmigen Ausgangssignalen der entsprechenden Strom-Frequenz-Wandler erfaßt. Da dieses beschriebene vorbekannte System notwendigerweise Strom-Frequenz-Wandler für den Betrieb in positive und in negative Energieflußrichtung erfordert, ist dies mit erhöhten Kosten verbunden, wobei manchmal ein Unterschied in den Charakteristiken der beiden Strom-Frequenz-Wandler auftritt, so daß ein Fehler in den Meßwerten für die positive und negative Energieflußrichtung zustande kommt.

Bei einem anderen vorbekannten System ist zwischen einen Leistungs-Strom-Wandler und einen Strom-Frequenz-Wandler ein Diskriminatorkreis zur Unterscheidung der Flußrichtung desjenigen Gleichstromes eingefügt, der als Ausgangssignal des Leistungs-Strom-Wandlers verwendet wird. Ferner ist unmittelbar im Abschluß an den Diskriminatorkreis ein Schaltkreis zur Umkehr der Flußrichtung des Ausgangssignals des Leistungs-Strom-Wandlers vorgesehen, durch den - wenn die Energieflußrichtung sich umkehrt - die Ausgangsflußrichtung durch die Wirkung des Diskriminatorkreises umgekehrt wird und die Ausgangsimpulse des Strom-Frequenz-Wandlers gleichzeitig unterschiedlichen Zähleinrichtungen für positiven und negativen Betrieb zugeführt sind, so daß die Leistungen entsprechend den unterschiedlichen Energieflußrichtungen separat integriert werden. Da ein einziger Strom-Frequenz-Wandler für beide Energieflußrichtungen genutzt werden kann, werden die Umwandlungscharakteristiken bei diesem System gleich denen, die im Fall, daß zwei Wandler mit gleicher Genauigkeit eingesetzt sind, erhalten werden. Jedoch entstehen hierbei Probleme bei der Unterscheidungsgenauigkeit für die Flußrichtungsunterscheidung, so daß ein fehlerhafter Betrieb bei geringer Last (oder einem niedrigen Energiefluß) zu befürchten ist. Speziell in dem Fall, daß das Ausgangssignal des Leistungs-Strom-Wandlers kein völlig konstanter Gleichstrom sondern ein pulsierender Gleichstrom ist, wird der Betrieb für einen Laststrom nahe bei Null ungenau.

Als weiteres vorbekanntes leistungs- und energieflußerfassendes System ist in der japanischen Patentver-öffentlichung Nr. 51-49 430 ein System offenbart, dessen Erfassungsgenauigkeit abhängig von der Kapazität eines

- 4 -

Kondensators ist, so daß es als Präzisionszähler, der eine hohe Langzeitstabilität erfordert, nicht geeignet ist.

Angesichts dieses Standes der Technik liegt der vorliegenden Erfindung die Aufgabe zugrunde, einen elektrischen Energieverbrauchszähler anzugeben, der den Energiefluß sowohl in positive als auch in negative Energieflußrichtung getrennt mit der gleichen und hervorragenden Genauigkeit zu erfassen vermag.

Offenbarung der Erfindung

Entsprechend der vorliegenden Erfindung wird die erwähnte Aufgabe gelöst durch den Einsatz eines Integrators, eines dem Integrator nachgeschalteten Schwellwertgliedes und eines nach dem Ladungskompensationsverfahren arbeitenden Strom-Frequenz-Wandlers, der in Abhängigkeit vom Signal des Schwellwertgliedes dem Eingang des Integrators für eine feste Zeitspanne den konstanten Strom zuführt, der gegenüber dem Ausgangsstrom des Leistungs-Strom-Wandlers umgekehrte Flußrichtung aufweist, wodurch das Ausgangssignal geändert wird, so daß diese Änderung als zum Ausgangsstrom des Leistungs-Strom-Wandlers proportionale Pulsfrequenz gewonnen werden kann. Entsprechend der vorliegenden Erfindung ist darüber hinaus dem Integrator ein Steuerkreis nachgeschaltet, der ein weiteres Schwellwertglied und ein Flip-Flop umfaßt, das dem zusätzlichen Schwellwertglied nachgeschaltet ist, so daß das Eingangssignal des Integrators durch das Ausgangssignal des Flip-Flop invertiert wird und so daß die Ausgangsimpulse des Strom-Frequenz-Wandlers auf die Zähleinrichtungen für positiven und negativen Betrieb aufgeteilt werden. Damit kann der Zählbetrieb für positive und negative Leistung exakt durch den Einsatz nur eines einzigen Strom-Frequenz-Wandlers durchgeführt werden, ohne daß die Vorteile des Ladungskompensationssystems verschlechtert werden.

## 0036893

- 5 -

<u>Kurzbeschreibung der Zeichnung</u>

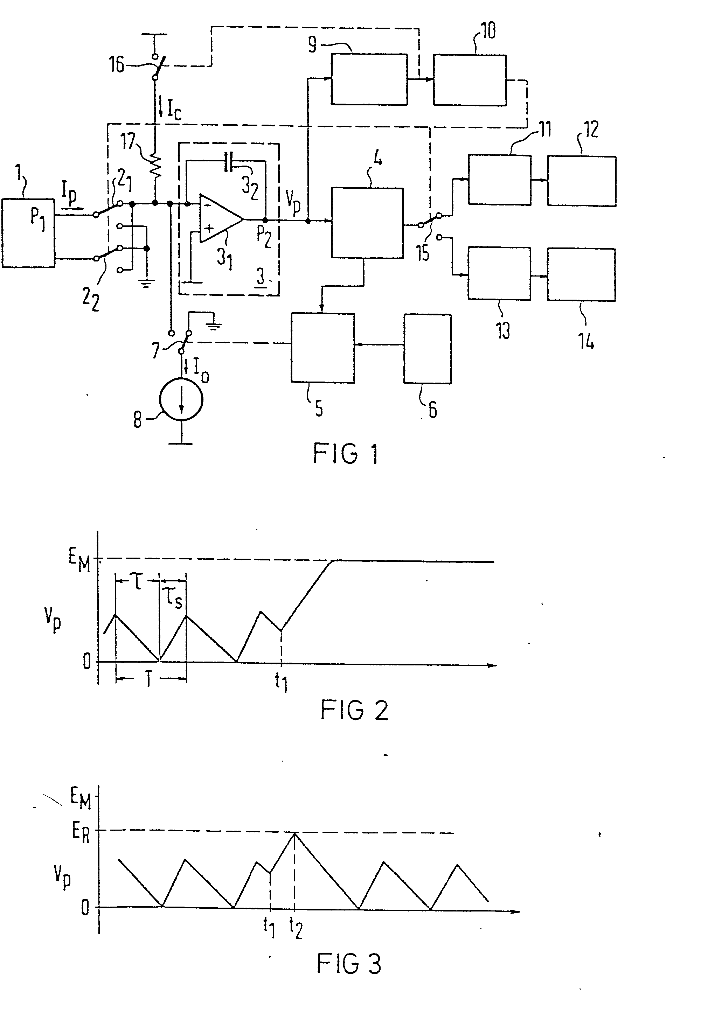

Fig. 1 stellt ein Blockdiagramm dar, das eine Ausführungsform einer Schaltungsanordnung zur Erfassung des elektrischen Energieverbrauchs darstellt. Die Figuren 2 bis 5 zeigen Wellenformdiagramme zur Veranschaulichung des Betriebs der in Fig. 1 dargestellten Schaltungsanordnung.

<u>Bestes Ausführungsbeispiel zur Ausführung der Erfindung</u>

Die erfindungsgemäße Schaltungsanordnung zur Erfassung der elektrischen Energie wird in Verbindung mit einer vorzugsweisen Ausführungsform und unter Bezugnahme auf die begleitende Zeichnung näher beschrieben.

Fig. 1 stellt ein Blockdiagramm dar, das eine Ausführungsform der Schaltungsanordnung zur Erfassung der geflossenen elektrischen Energie entsprechend der Erfindung veranschaulicht. Ein mit dem Bezugszeichen 1 belegter Leistungs-Strom-Wandler 1 erzeugt einen den Produkt von Spannung und Strom und damit der Leistung in der elektrischen Versorgungsleitung proportionalen Gleichstrom. Es sei nun angenommen, daß der der Leistung proportionale Gleichstrom $I_p$ im Fall eines Energieflusses in positiver Richtung in der durch den eingezeichneten Pfeil veranschaulichten Richtung an einer Ausgangsklemme $P_1$ des Leistungs-Strom-Wandlers 1 auftritt. Darüber hinaus fließt dieser Ausgangsstrom $I_p$ des Leistungs-Strom-Wandlers 1, wenn die gekoppelten Schalter $2_1$ und $2_2$ sich in der eingezeichneten Stellung befinden, in einen Integrator 3, der durch einen Operationsverstärker $3_1$ und einen Kondensator $3_2$ gebildet ist. Dieser Kondensator $3_2$ des Integrators 3 wird durch den Strom $I_p$ entladen, so daß die Spannung $V_p$ an der Ausgangsklemme $P_2$ des Integrators 3 in Abhängigkeit vom Eingangsstrom nach und nach absinkt. Ein Schwellwertglied 4 überwacht die Spannung $V_p$ und gibt ein Grenzwertsignal an einen Schaltersteuerkreis 5 ab, wenn diese Spannung einen vorgegebenen Spannungsgrenzwert unterschreitet. Auf dieses Signal hin schaltet der Schaltersteuerkreis 5 einen Schalter 7 für die Dauer $\mathcal{T}_s$ eines Ausgangsimpulses eines Oszillators 6, der mit vorgegebener Schwingungsdauer schwingt, um. Im umgeschalteten Zustand verbindet der Schalter 7 eine Konstantstromquelle 8 mit dem Eingang des Integrators 3, wobei der konstante Strom $I_o$ der Konstantstromquelle 8 gegenüber dem Eingangsstrom $I_p$ des Integrators 3 umgekehrte Stromflußrichtung aufweist. Vor dem Umschaltvorgang des Schalters 7 besteht der gesamte Eingangsstrom des Integrators 3 aus $I_p$. Nach der Umschaltoperation jedoch wird der Konstantstrom $I_o$ der Konstantstromquelle 8 gleichzeitig zugeführt, so daß der Kondensator $3_2$ des Integrators 3 durch die Differenz aus $I_p$ und $I_o$ (wobei $I_p - I_o$ kleiner Null ist) geladen, so daß die Ausgangsspannung $V_p$ des Integrators 3 während der Zeitspanne $\mathcal{T}_s$ angehoben wird. Nach Beendigung dieser Zeitspanne $\widetilde{\mathcal{T}}_s$, erfolgt eine Entladung wiederum allein durch den Eingangsstrom $I_p$, so daß die Ausgangsspannung $V_p$ nach und nach absinkt. Wenn die Ausgangsspannung $V_p$ des Integrators 3 den Grenzwert des Schwellwertgliedes 4 erreicht, wird der Schalter 7 wiederum durch den Schaltersteuerkreis umgeschaltet, so daß der Kondensator wiederum - wie oben beschrieben - durch die Stromdifferenz $I_p - I_o$ aufgeladen wird. Diese Vorgänge wiederholen sich in der Folge.

Die Änderung der Ausgangsspannung $V_p$ während dieser Auf- und Entladevorgänge des Kondensators des Integrators ist in Fig. 2 für eine Periode T dargestellt. Die Zeitspanne, während der der Kondensator $3_2$ durch den Eingangsstrom $I_p$ am Integrator 3 entladen wird, ist mit $\mathcal{T}$ bezeichnet, während die Zeitspanne, während der der Kondensator $3_2$ durch den Strom $I_p - I_o$ geladen wird, mit $\widetilde{\mathcal{T}}_s$ bezeichnet ist. Da die dem Kondensator $3_2$ zugeführten und ent-

- 7 -

nommenen Ladungsmengen während der Entladezeit $\mathcal{T}$ und der Aufladezeit $\mathcal{T}_s$ gleich sind, gilt die folgende Beziehung:

$$I_p \cdot \mathcal{T} = (I_o - I_p) \cdot \mathcal{T}_s \qquad (1)$$

Da $T = \mathcal{T} + \mathcal{T}_s$ und die Frequenz $f = 1 / T$ sind, gelten die folgenden Gleichungen:

$$T = \frac{I_o \cdot \mathcal{T}_s}{I_p} \qquad (2);$$

und

$$f = \frac{1}{I_o \cdot \mathcal{T}_s} \cdot I_p \qquad (3).$$

Daher kann die Frequenz f proportional zum Eingangsstrom $I_p$ erhalten werden, wenn das Signal entweder des Schwellwertgliedes 4 oder Schaltersteuerkreises 5 in Form eines Impulses gewonnen ist. Da darüber hinaus die Frequenz f nur vom Reziprokwert von $I_o \cdot \mathcal{T}_s$ abhängt, nicht jedoch von der Kapazität des Kondensators $3_2$, kann eine gute Langzeitstabilität erwartet werden.

Bei dem oben beschriebenen Strom-Frequenz-Wandler nach dem Ladungskompensationsverfahren ist die Umsetzung nur in dem Fall möglich, wenn der Eingangsstrom $I_p$ des Integrators 3 in eine Richtung fließt. Der mögliche Zählerbetrieb ist unter der vorerwähnten Annahme nur auf die Leistungserfassung in positiver Energieflußrichtung beschränkt, wenn der Ausgangsstrom $I_p$ des Leistungs-Strom-Wandlers 1 in die eingezeichnete Richtung fließt. Wie beispielsweise aus Fig. 2 ersichtlich ist, wird die Flußrichtung des Ausgangsstromes $I_p$ des Leistungs-Strom-Wandlers 1 geändert, wenn der Energiefluß im Zeitpunkt $t_1$ umgekehrt wird. Demzufolge steigt die Ausgangsspannung $V_p$ des Integrators 3 nach dem Zeitpunkt $t_1$ nach und nach an, bis sie die Sättigungsspannung $E_M$ des Operationsverstärkers $3_1$ erreicht, so daß die Strom-Frequenz-Wandlung schließlich unterbrochen ist. Diese Charakteristiken treten in dem Fall auf, daß die Schaltungsanordnung nur den Energiefluß in einer Richtung erfaßt. In diesem Fall können die Eigenschaften einer umkehrverhindernden Einrichtung eines konventionellen Wattmeters, das mit einer Scheibe ausgestattet ist, mit Vorteil genutzt werden.

Entsprechend der vorliegenden Erfindung wird die Richtungsänderung des Energieflusses aus der Ausgangsspannung des Integrators in einem geeigneten Zeitpunkt vor der durch den Richtungswechsel des Energieflusses bewirkten Unterbrechung des Betriebs des Integrators erfaßt, so daß die Flußrichtung des Eingangsstromes $I_p$ des Integrators umgekehrt wird, um die Flußrichtungen der Eingangsströme $I_p$ und $I_o$ umzusteuern. Dadurch wird der Integrator in die Lage versetzt, die Auf- und Entladeoperationen des Kondensators des Integrators in Übereinstimmung mit der nunmehr geänderten Energieflußrichtung durchzuführen, so daß der Impuls, der der Leistung in diesem Zeitpunkt entspricht, einer anderen Zähleinrichtung zugeführt wird, wodurch die Leistungen für positive bzw. negative Energieflußrichtungen erfaßt werden können.

Wie in Fig. 1 dargestellt ist, ist an der Ausgangsklemme $P_2$ des Integrators 3 zusätzlich zum Schwellwertglied 4 sowohl ein weiteres Schwellwertglied 9, dessen Grenzwert niedriger liegt als die Sättigungsspannung $E_M$ des Integrators 3, als auch ein dem weiteren Schwellwertglied 9 nachgeschaltetes Flip-Flop 10, dem das

- 9 -

Ausgangssignal des weiteren Schwellwertgliedes 9 zugeführt ist, vorgesehen. Wie in Fig. 3 dargestellt ist, liegt der Grenzwert des weiteren Schwellwertgliedes 9 bei einer Zwischenspannung $E_R$ zwischen dem normalen Betriebsbereich des Integrators 3 und der Sättigungsspannung $E_M$. In Fig. 3 ist die Energieflußrichtung im Zeitpunkt $t_1$ umgekehrt, so daß die Flußrichtung des Ausgangsstromes $I_p$ des Leistungs-Strom-Wandlers 1 geändert wird. Die Ausgangsspannung $V_p$ des Integrators 3 steigt nach dem Zeitpunkt $t_1$ weiter an, bis sie im Zeitpunkt $t_2$ die Spannung $E_R$ erreicht. Das Flip-Flop 10 ändert in diesem Zeitpunkt seinen Zustand auf das Grenzwertsignal hin, das durch Überwachung der Ausgangsspannung mittels des weiteren Schwellwertgliedes 9 zustande kommt. Wenn der Zustandswechsel des Flip-Flop 10 erfolgt, wird das Ausgangssignal des Schwellwertgliedes 4 gleichzeitig mit dem Umschalten der in Fig. 1 dargestellten gekoppelten Umschalter $2_1$ und $2_2$ durch Umschalten eines Schalters 15 anstelle des Ausgangsgliedes für positiven Energiefluß dem Ausgangsglied für negativen Energiefluß zugeführt. Das Ausgangsglied für positiven Energiefluß besteht aus einem Frequenzteiler 11 und einer Zähleinrichtung 12. Das Ausgangsglied für negativen Energiefluß besteht aus einem Frequenzteiler 13 und einer Zähleinrichtung 14. Die Betrachtung der Flußrichtung des Ausgangsstromes $I_p$ des Leistungs-Strom-Wandlers 1 zeigt, daß durch den Umschaltvorgang der Umschalter $2_1$ und $2_2$ die Richtung des Stromes $I_p$ zum Integrator 3 nunmehr dieselbe ist wie vor dem Wechsel der Energieflußrichtung; denn die Polaritäten der Ströme $I_p$ und $I_o$ werden umgekehrt, so daß die Ausgangsspannung $V_p$ des Integrators 3 nach dem Zeitpunkt $t_2$ verringert wird. Darüber hinaus wird - wenn die Ausgangsspannung $V_p$ den Grenzwert des Schwellwertgliedes 4 erreicht - das Grenzwertsignal dem Schaltersteuerkreis 5 zugeführt, um den Schalter 7 umzuschalten, so daß der Kondensator $3_2$ mit der Stromdifferenz aus dem

konstanten Strom $I_o$ und dem Eingangsstrom $I_p$ geladen wird. Danach wiederholen sich die Aufladevorgänge und Entladevorgänge des Integrators 3 in ständiger Folge. Die vom Schwellwertglied 4 erzeugte leistungsproportionale Pulsfrequenz wird über den Schalter 15 für negative Energieflußrichtung dem Frequenzteiler 13 zugeführt, so daß der negative Energiefluß durch die Zähleinrichtung 14 angezeigt wird.

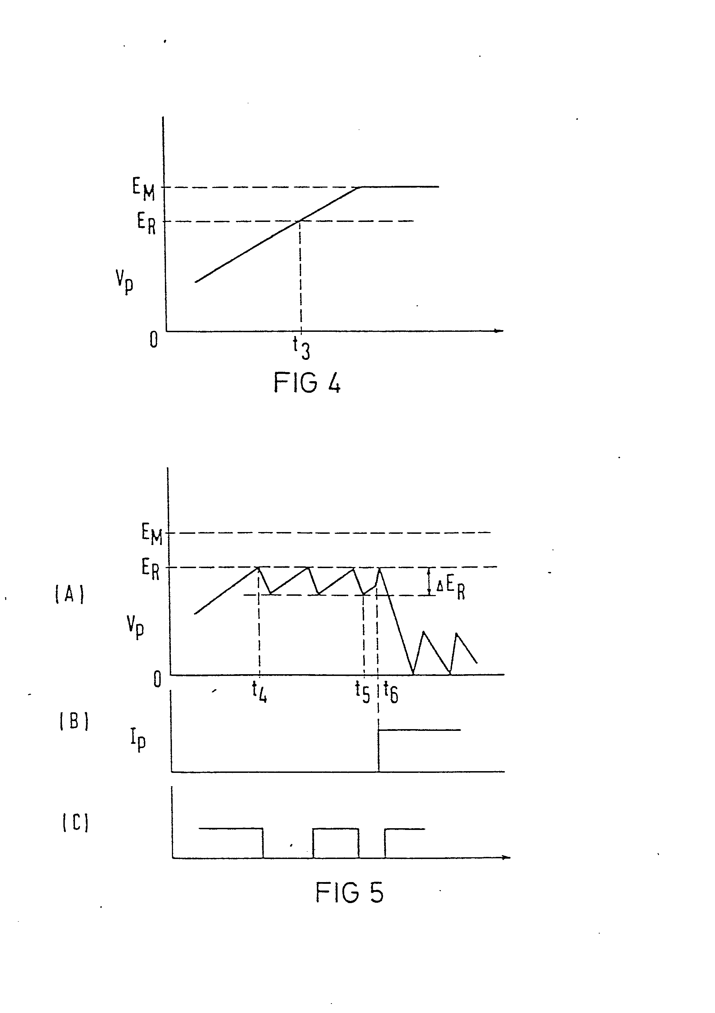

Das Ausgangssignal des weiteren Schwellwertgliedes steht am Flip-Flop 10 an, um dessen Zustand zu ändern, wobei gleichzeitig ein Schalter 16 vom geöffneten in den geschlossenen Zustand übergeht. Wenn der Schalter 16 geschlossen ist, wird der Eingang des Integrators 3 über einen Widerstand 17 mit einem Kompensationsstrom $I_c$ gespeist. Die Wirkung dieses Kompensationsstromes wird unter Bezugnahme auf die Figuren 4 und 5 beschrieben. In dem Operationsverstärker $3_1$, der im Integrator 3 verwendet wird, treten eine Offsetspannung und ein Offsetstrom auf. Diese Offsetspannung und dieser Offsetstrom verändern die Ausgangsspannung $V_p$ auch in dem Fall, daß das Eingangssignal des Integrators 3 Null ist. Deswegen werden im allgemeinen Offsetspannung und Offsetstrom durch einen Offsetsteuerkreis verringert. Im Fall des Ladungskompensationsverfahrens jedoch erzeugt das Schwellwertglied 4 einen Impuls, wenn die Ausgangsspannung $V_p$ bei einem Eingangssignal von Null verringert wird. In anderen Worten bedeutet dies, daß die Offseteinstellung vorzugsweise so gemacht wird, daß das Ausgangssignal gegenüber einem absolut unveränderlichen Zustand geringfügig ansteigt, da ein "Kriechen" stattfindet. Damit steigt die Ausgangsspannung $V_p$ langsam an, wenn der Zustand "Eingangssignal Null" oder "Niedrige Last" für eine lange Zeitspanne andauert. Wie in Fig. 4 dargestellt ist, steigt die Ausgangsspannung $V_p$ sogar weiterhin an, selbst wenn der Grenzwert $E_R$ im Zeitpunkt $t_3$ erreicht wird, bei dem das weitere Schwellwertglied 9 wirksam wird. Dies resultiert aus der Tatsache, daß nichts geschieht, selbst wenn das Flip-Flop 10 im Zeitpunkt $t_3$ seinen Zustand ändert und dabei die gekoppelten Umschalter $2_1$ und $2_2$ betätigt, da der Eingangsstrom $I_p$ den Wert Null aufweist. Falls die Schaltungsanordnung vor dem Zeitpunkt $t_3$ in dem Betriebszustand zur Erfassung des Energieflusses in positive Richtung befindlich ist, stellt es sich heraus, daß nach dem Zeitpunkt $t_3$ in die Betriebsart für Energiefluß in negative Richtung umgeschaltet wurde. Erfolgt andererseits nach dem Zeitpunkt $t_3$ der Energiefluß in positive Richtung, dann steigt die Ausgangsspannung $V_p$ des Integrators 3 weiter an, da die Schaltungsanordnung in dem Betriebszustand für negative Energieflußrichtung befindlich war. Da das Ausgangssignal des Integrators 3 inzwischen den Sättigungsbereich erreicht hat, findet jedoch kein Signalwechsel statt. Dies bedeutet in anderen Worten, daß der Betrieb der Schaltungsanordnung unterbrochen ist, wenn der Betrieb normal durchgeführt werden soll.

Um eine solche Unterbrechung der Funktion auszuschließen, wird der Schalter 16 vorzugsweise durch das Grenzwertsignal des weiteren Schwellwertgliedes 9 betätigt, wobei der Integrator 3 über den Widerstand 17 mit dem Kompensationsstrom $I_c$ beaufschlagt wird. Dieser hat eine derartige Polarität, daß die Ausgangsspannung $V_p$ des Integrators 3 in Richtung auf Null hin umgekehrt wird. Hierbei ist der Widerstandswert des Widerstandes 17 vorzugsweise so gewählt, daß der Kompensationsstrom $I_c$ größer wird als der maximale Ausgangsstrom $I_p$ des Leistungs-Strom-Wandlers 1.

Die Wirkungsweise im Fall der Anwendung eines solchen Kompensationsstromes $I_c$ ist in Fig. 5 veranschaulicht. In Fig. 5 zeigt (A) den Verlauf der Ausgangsspannung $V_p$

des Integrators 3, (B) den Verlauf des Ausgangsstromes $I_p$ des Leistungs-Strom-Wandlers 1 und (C) den Ausgangszustand des Flip-Flop 10. Zunächst, wenn der Eingangsstrom $I_p$ Null ist, steigt die Ausgangsspannung $V_p$ langsam an, bis sie die Grenzwertspannung $E_R$ im Zeitpunkt $t_4$ erreicht, worauf das weitere Schwellwertglied 9 in Aktion tritt. Dadurch wird der Zustand des Flip-Flop 10 geändert, so daß die Betriebsweise "Erfassung für negative Energieflußrichtung" beginnt und gleichzeitig der Schalter 16 eingeschaltet wird. Dadurch wird der Kompensationsstrom $I_c$ in den Integrator 3 eingespeist, so daß die Ausgangsspannung $V_p$ des Integrators 3 um $\Delta E_R$ erniedrigt wird. Dieser Wert $\Delta E_R$ ist die Breite der Hysterese des weiteren Schwellwertgliedes 9. Wenn die Ausgangsspannung $V_p$ von dem Schwellwert $E_R$ um die Breite $\Delta E_R$ abgesenkt ist, wird der Kompensationsstrom $I_c$ unterbrochen, so daß das Ausgangssignal des Integrators 3 erneut ansteigt, bis es den Grenzwert wieder erreicht. Hierbei tritt das weitere Schwellwertglied 9 wiederum in Aktion und führt einen Zustandswechsel des Flip-Flop 10 herbei, der dem Betriebszustand "Erfassung für positive Energieflußrichtung" entspricht. Die im Voranstehenden beschriebenen Vorgänge wiederholen sich nun.

Im Zeitpunkt $t_5$ wird das Flip-Flop 10 in einen Zustand gebracht, der der Betriebsweise für negative Energieflußrichtung entspricht. Wenn der Energiefluß im Zeitpunkt $t_6$ positiv wird, steigt die Ausgangsspannung $V_p$ des Integrators abrupt auf die Spannung $E_R$ an, so daß das Schwellwertglied 9 und das nachgeschaltete Flip-Flop 10 ansprechen und den Erfassungszustand für positive Energieflußrichtung einleiten. Nach diesem Zeitpunkt $t_6$ wird die Ausgangsspannung $V_p$ des Integrators abgesenkt, so daß der normale Strom-Frequenz-Wandler-Betrieb wieder aufgenommen wird, und der resultierende Ausgangsimpuls

- 13 -

der Zähleinrichtung für den Betrieb bei positivem Energiefluß zugeführt.

Die Schalter $2_1$, $2_2$, 7, 15 und 16 im Ausführungsbeispiel der beschriebenen Erfindung sind vorzugsweise als elektronische Schalter oder als Schaltelemente mit ähnlicher Wirkung ausgeführt.

Wie im Voranstehenden beschrieben wurde, wird bei der erfindungsgemäßen Schaltungsanordnung zur Erfassung der elektrischen Energie ein nach dem Ladungskompensationsverfahren arbeitender Strom-Frequenz-Wandler verwendet, dessen Eingangspolarität durch einen Schalter umschaltbar ist, um die Erfassung des Energieverbrauchs bei positiver und negativer Energieflußrichtung unter Verwendung nur eines einzigen Strom-Frequenz-Wandlers und einer einzigen Konstantstromquelle 8 zu ermöglichen. Die erreichbaren Vorteile liegen dabei einerseits in der Unkompliziertheit der Schaltungsanordnung und andererseits in den geringen Meßfehlern sowohl bei positiver als auch bei negativer Energieflußrichtung. Da die erfindungsgemäße Schaltungsanordnung nicht auf die Unterscheidung der Flußrichtung des Ausgangsstromes des Leistungs-Strom-Wandlers abstellt, sondern auf die Unterscheidung in der Richtung des Energieflusses als Ergebnis des Spannungsverlaufs am Ausgang des Integrators, wird die Genauigkeit des Umschaltzeitpunktes zwischen positiver und negativer Energieflußrichtung beträchtlich verbessert.

Industrielle Anwendbarkeit
Die erfindungsgemäße Schaltungsanordnung zur Erfassung des Energieflusses gestattet die Erfassung eines Wechsels der Energieflußrichtung unter Einsatz nur eines einzigen Systems, so daß diese Schaltungsanordnung vorzugsweise bei Anwendungsfällen mit zwei Energieflußrichtungen beim Energieaustausch zwischen mehreren elektrischen Energieversorgungseinrichtungen und auch zwischen elektrischen Energieversorgungseinrichtungen und Fabrikanlagen von Abnehmern, wie beispielsweise Generatorsätzen für Hochöfen, einsetzbar ist.

5 Figuren
3 Patentansprüche

Patentansprüche

1. Schaltungsanordnung zur Erfassung elektrischer Energie, die folgende Funktionselemente aufweist:

- einen Leistungs-Strom-Wandler zur Bildung des Produktes aus Strom und Spannung einer elektrischen Versorgungsleitung, deren Energiefluß in Übereinstimmung mit der Richtung dieses Energieflusses in positiver bzw. negativer Richtung erfaßt werden soll,
- einen Integrator, dem das Ausgangssignal des Leistungs-Strom-Wandlers zugeführt ist,
- ein Schwellwertglied zur Überwachung der Hohe des Ausgangssignals des Integrators,
- eine Stromquelle, die in Abhängigkeit vom Grenzwertsignal des Schwellwertgliedes für eine vorgegebene Zeitspanne zusätzlich an dem Ausgangssignal des Leistungs-Strom-Wandlers in den Integrator einen konstanten Strom einspeist, der bezüglich des vom Leistungs-Strom-Wandler stammenden Eingangssignals umgekehrte Polarität aufweist, wodurch der Verlauf des Ausgangssignals des Integrators umgekehrt wird,
- Zähleinrichtung zur Erfassung der Zahl der Umkehrungen des Ausgangssignals des Integrators, die in Form einer Impulsfrequenz zur Verfügung stehen,

d a d u r c h   g e k e n n z e i c h n e t ,   daß Schalter ($2_1$, $2_2$) zum Umschalten der Eingangspolarität des vom Leistungs-Strom-Wandler (1) an den Integrator (3) abgegebenen Signals in umgekehrte Richtung vorgesehen sind und daß Schaltersteuerkreise (9, 10) einerseits zum Betätigen dieser Schalter, wenn die Richtung des Energieflusses sich umkehrt, so daß das Ausgangssignal des Integrators (3) einen vorgegebenen Grenzwert überschreitet, und andererseits zum Anschalten der Zähleinrichtungen entsprechend der Richtung des Energieflusses vorgesehen sind.

2. Schaltungsanordnung nach Anspruch 1, d a d u r c h
g e k e n n z e i c h n e t , daß der Schalter-
steuerkreis ein weiteres Schwellwertglied (9) und ein
Flip-Flop (10) aufweist, wobei der Grenzwert des zweiten Schwellwertgliedes (9) zwischen dem normalen Betriebsbereich des Integrators (3) und dessen Sättigungsspannung liegt, wodurch ein Schalter (15) und damit die
Zähleinrichtungen (12, 14) entsprechend der Richtung
des Energieflusses in Abhängigkeit vom Ausgangssignal
des Flip-Flop (10) geschaltet werden.

3. Schaltungsanordnung nach Anspruch 2, d a d u r c h
g e k e n n z e i c h n e t , daß ein Schaltkreis
vorgesehen ist, der in Abhängigkeit vom Ausgangssignal
des Flip-Flop (10) den Integrator (3) mit einem Kompensationsstrom speist, um das Ausgangssignal des Integrators (3) in Richtung auf den Wert Null hin abzu-
senken.

0036893

1/2

FIG 1

FIG 2

FIG 3

2/2

0036893

FIG 4

FIG 5

# INTERNATIONAL SEARCH REPORT

**0036893**

International Application No  PCT/JP80/00241

## I. CLASSIFICATION OF SUBJECT MATTER (If several classification symbols apply, indicate all) 3

According to International Patent Classification (IPC) or to both National Classification and IPC

Int. Cl.$^3$   G01R 11/00

## II. FIELDS SEARCHED

| Minimum Documentation Searched 4 | |
|---|---|
| Classification System | Classification Symbols |
| I P C | G01R 11/00, G01R 21/00 |

| Documentation Searched other than Minimum Documentation to the Extent that such Documents are Included in the Fields Searched 5 |
|---|
| Jitsuyo Shinan Koho                     1926 – 1980 |
| Kokai Jitsuyo Shinan Koho        1971 – 1980 |

## III. DOCUMENTS CONSIDERED TO BE RELEVANT 14

| Category * | Citation of Document, 16 with indication, where appropriate, of the relevant passages 17 | Relevant to Claim No. 18 |
|---|---|---|
| X | US, A, 3,731,190,          1973-5-1<br>Siemens Aktiengesellschaft | 1-3 |
| A | US, A, 3,875,508,          1975-4-1<br>See column 15, line 37 to column 17, line 5<br>General Electric Company | 1-3 |

* Special categories of cited documents: 15

"A" document defining the general state of the art

"E" earlier document but published on or after the International filing date

"L" document cited for special reason other than those referred to in the other categories

"O" document referring to an oral disclosure, use, exhibition or other means

"P" document published prior to the International filing date but on or after the priority date claimed

"T" later document published on or after the international filing date or priority date and not in conflict with the application, but cited to understand the principie or theory underlying the invention

"X" document of particular relevance

## IV. CERTIFICATION

| Date of the Actual Completion of the International Search 2 | Date of Mailing of this International Search Report 3 |
|---|---|
| December 8, 1980 (08.12.80) | December 15, 1980 (15.12.80) |
| International Searching Authority 1 | Signature of Authorized Officer 10 |
| Japanese Patent Office | |

Form PCT/ISA/210 (second sheet) (October 1977)